# DEMANDE DE BREVET EUROPEEN

(11) **EP 2 157 476 A1**
(43) Date de publication de la demande: **24.02.2010**
(21) Numéro de dépôt: 08162693.9
(22) Date de dépôt: 20.08.2008
(51) Int. Cl.: G03F 7/00, G03F 7/40

(54) **Procédé de fabrication de pièces métalliques multi-niveaux par la technique LIGA-UV**

(71) Demandeur: Nivarox-FAR S.A., 2400 Le Locle (CH)
(72) Inventeur: Fiaccabrino, Jean-Charles, 1421 Grandevent (CH); Rey-Mermet, Gilles, 1870 Monthey (CH)
(74) Mandataire: Ravenel, Thierry Gérard Louis

(57) **Abrégé**

Le procédé de fabrication d'une microstructure métallique multi-niveaux comprend les étapes consistant à :
a) se munir d'un substrat (1) comportant une surface conductrice (2) ;
b) recouvrir la surface conductrice (2) d'une première couche de résine photosensible (3) ;
c) irradier la première couche de résine photosensible (3) à travers un masque (4) correspondant à l'empreinte désirée ;
d) développer la première couche de résine photosensible (3) de manière à creuser dans celle-ci des ouvertures et à obtenir ainsi un premier niveau d'un moule en résine, les ouvertures dans la première couche de résine laissant apparaître la surface conductrice (2) du substrat ;
e) déposer une nouvelle couche de résine photosensible (6) sur la couche de résine développée (3), de manière à recouvrir cette dernière et à remplir les ouvertures dans celle-ci.
f) irradier la nouvelle couche de résine photosensible (6) à travers un masque (7) correspondant à l'empreinte désirée ;
g) développer la nouvelle couche de résine photosensible (6) de manière à creuser dans celle-ci des ouvertures et à obtenir un moule en résine multi niveaux, les ouvertures dans le moule multi niveaux laissant apparaître la surface conductrice (2) du substrat.
h) déposer galvaniquement un métal ou un alliage dans les ouvertures du moule en résine multi niveaux.
i) éliminer les couches de résine de manière à faire apparaître une structure métallique multi niveaux (8) constituée par ledit métal ou alliage déposé dans les ouvertures.

## Description

La présente invention concerne un procédé de fabrication d'une structure métallique multi-niveaux par une technique de photolithographie UV et de dépôt galvanique.

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible. Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique.
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en oeuvre de manière itérative pour obtenir des structures métalliques ayant plus de deux niveaux. Un inconvénient de ce procédé et la nécessité d'obtenir une surface supérieure sensiblement plane lors de chaque étape de dépôt galvanique. Une solution à ce problème est décrite dans le document de brevet EP 1'835'050 qui enseigne qu'il est possible d'obtenir la surface plane désirée en usinant la structure métallique et le moule *in situ* après l'étape du dépôt galvanique. Toutefois, la présence d'installations d'usinage en salle blanche peut potentiellement créer plus de problèmes qu'elle n'en résout. L'alternative qui consiste à faire des allers-retours entre une installation d'usinage et la salle blanche n'est pas non plus compatible avec l'extrême propreté généralement nécessaire pour la photoglyptographie et le dépôt galvanique.

Le document de brevet EP 0'851'295 décrit un autre procédé pour la fabrication de structures métalliques multi-niveaux dans des moules réalisés par photolithographie UV. Ce deuxième procédé comprend les étapes suivantes :
a) créer sur un substrat une couche métallique sacrificielle,
b) étaler une couche de résine époxy photosensible d'une épaisseur comprise entre 150 et 700 micron,
c) chauffer ladite couche entre 90° et 95° pendant une durée dépendant de l'épaisseur déposée (pre-bake),
d) irradier la couche de résine avec un rayonnement UV à travers un masque correspondant au contour d'un niveau de la structure à obtenir,
e) effectuer un recuit de ladite couche pour provoquer la polymérisation (post-bake),
f) reproduire au moins une fois les étapes b) à e) en utilisant si nécessaire en fonction du contour désiré pour la structuration de la nouvelle couche de photorésist, un masque différent pour l'étape d),
g) développer les couches de résine superposées en dissolvant les parties non irradiées de façon à obtenir un moule en résine époxy,
ii) former une métallisation primaire sur toute la surface du moule, puis recouvrir complètement le moule par des dépôts galvaniques de façon à former la structure métallique multi-niveaux,
h) séparer le substrat de l'ensemble formé par le moule en résine époxy et la structure métallique,
iii) séparer la structure multi-niveaux du moule en résine.

Un avantage de ce deuxième procédé est que le moule en résine est entièrement réalisé avant l'étape de dépôt galvanique. Un éventuel usinage de la structure métallique multi-niveaux peut donc être effectué, après-coup, hors de la salle blanche, sans risque de contaminer cette dernière. Toutefois, ce deuxième procédé présente également certains inconvénients. En particulier, les couches de résine superposées sont développées lors de la même étape. Dans ces conditions, l'étape de pre-bake de la deuxième couche de photorésist constitue forcément également un post-bake de la première couche. Il est donc très difficile d'adapter le température et la durée des recuits de manière optimum.

Un but de la présente invention est donc de fournir un procédé de fabrication d'une structure métallique multi-niveaux par des techniques de photolithographie UV et de dépôt galvanique qui remédie aux inconvénients des procédés de l'art antérieur susmentionnés. La présente invention atteint ce but en fournissant un procédé de fabrication d'une microstructure métallique multicouche par photolithographie UV et dépôt galvanique caractérisé en ce qu'il comprend les étapes consistant à :
a) se munir d'un substrat comportant une surface conductrice;
b) recouvrir la surface conductrice du substrat une première couche de résine photosensible ;
c) irradier la première couche de résine photosensible à travers un masque correspondant à l'empreinte désirée ;
d) développer la première couche de résine photosensible de manière à creuser dans celle-ci des ouvertures et à obtenir ainsi un premier niveau d'un moule en résine, les ouvertures dans la première couche de résine laissant apparaître la surface conductrice du substrat ;
e) déposer une nouvelle couche de résine photosensible sur la couche de résine développée, de manière à recouvrir cette dernière et, de préférence, à remplir les ouvertures dans celle-ci ;
f) irradier la nouvelle couche de résine photosensible à travers un masque correspondant à l'empreinte désirée ;
g) développer la nouvelle couche de résine photosensible de manière à creuser dans celle-ci des ouvertures et à obtenir un moule en résine multi niveaux, les ouvertures dans le moule multi niveaux laissant apparaître la surface conductrice du substrat ;
h) passer directement à l'étape j) ou, si désiré, répéter d'abord les étapes e) à i) du procédé pour ajouter une couche supplémentaire au moule multi niveaux ;
i) déposer galvaniquement un métal ou un alliage dans les ouvertures du moule en résine multi niveaux ;
j) éliminer les couches de résine de manière à faire apparaître une structure métallique multicouche constituée par ledit métal ou alliage déposé dans les ouvertures.

On comprendra que, comme avec le deuxième procédé de l'art antérieur, selon la présente invention la pièce métallique multi-niveaux est formée en une seule étape de croissance galvanique (l'étape J). Toutefois, conformément à l'invention, les différentes couches de résine formant le moule en photorésisit sont développées séparément l'une après l'autre. Il est donc possible d'adapter séparément température et durée pour le pre-bake d'une couche supérieure et le post-bake de la couche inférieure.

Un autre avantage du procédé selon la présente invention et qu'il permet d'obtenir des flancs commun à deux niveaux, ce qui n'est pas possible avec le premier procédé décrit plus haut.

Encore un autre avantage de la présente invention est que, contrairement au deuxième procédé de l'art antérieur décrit plus, il offre la possibilité d'utiliser des résines photosensibles de nature différente pour les différents niveaux. On peut par exemple envisager d'utiliser un photorésist négatif pour le premier niveau et un photorésist positif pour le deuxième niveau. Cette possibilité permet de réaliser plus facilement certaines structures aux formes complexes.

Selon une première variante de mise oeuvre, le procédé comporte, après l'étape d), l'étape de former une surface conductrice sur les parties subsistantes de la surface de la couche de résine développée à l'étape précédente.

Alternativement, selon une seconde variante, l'étape de former une surface conductrice sur la première couche de résine photosensible peut se placer entre l'étape b) et l'étape c) ou entre l'étape c) et l'étape d). Selon encore une autre variante, la couche conductrice peut être formée entre l'étape g) et l'étape h) une fois les moules en photorésist réalisés.

D'autres caractéristiques et avantages du procédé selon la présente invention apparaîtront à la lecture de la description qui va suivre, donnée uniquement à titre d'exemple non limitatif, et faite en référence aux dessins annexés dans lesquels :

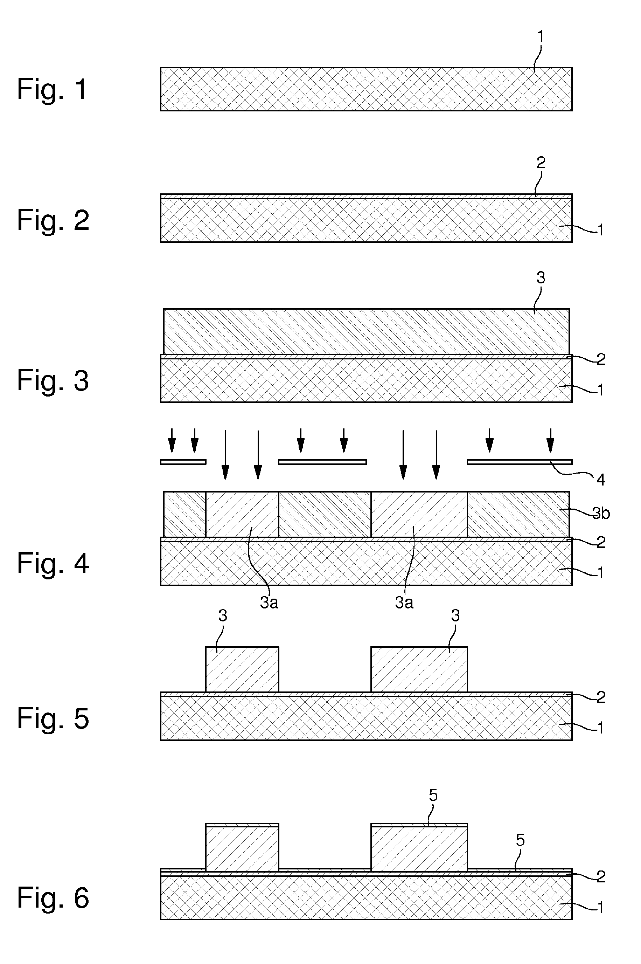

- les figures 1 à 13 illustrent différentes étapes de procédé correspondant à un mode particulier de mise en oeuvre du procédé de l'invention.

Selon la présente invention, le procédé comporte l'étape de se munir d'un substrat comportant une surface conductrice. Dans le mode d'implémentation particulier illustré dans les figures, le substrat 1 est constitué par une plaquette de silicium, de verre ou de céramique (figure 1) sur laquelle on a préalablement déposé par évaporation une couche conductrice 2 (figure 2). Cette couche conductrice 2 est prévue servir de couche d'amorçage, c'est-à-dire de cathode, lors d'un dépôt galvanique ultérieur. Typiquement, la couche d'amorçage 2 peut être formée d'une sous couche de chrome ou de titane recouverte d'une couche d'or ou de cuivre.

Selon une variante non représentée, avant de déposer la couche d'amorçage 2, on dépose d'abord sur le substrat par vaporisation sous vide une couche sacrificielle qui peut par exemple être réalisée en aluminium. Cette couche a typiquement une épaisseur de l'ordre d'un dixième de micron, et elle est prévue pour permettre de séparer la structure métallique multi niveau du substrat à la fin du procédé. Selon encore une autre variante, une même couche de métallisation peut remplir à la fois la fonction de couche sacrificielle et celle de couche d'amorçage. D'autre part, au lieu de la vaporisation sous vide, il est possible d'utiliser le dépôt galvanique comme technique pour former une couche sacrificielle.

Alternativement, le substrat peut être formé par une plaque en acier inoxydable ou en un autre métal. On comprendra que dans ces conditions, il n'est pas nécessaire de déposer une couche conductrice. Toutefois, la surface d'amorçage devra en général être dégraissée avant usage.

L'étape suivante (figure 3) consiste à recouvrir la surface conductrice du substrat d'une première couche de résine photosensible. La résine utilisée est de préférence une résine à base d'époxy octofonctionnelle disponible chez Shell Chemical sour la référence SU-8. Cette résine comprend également un photoinitiateur choisi parmi les sels de triarylsulfonium tels que ceux décrits dans le brevet US 4,058,401. Cette résine constitue un photorésist négatif qui est conçu pour polymériser sous l'action d'un rayonnement UV.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La résine 3 peut être déposée sur la couche d'amorçage 2 à l'aide de toute technique connue de l'homme du métier ; par exemple, à la tournette (spin coating), par application au cylindre, ou encore par laminage lorsqu'il s'agit d'une résine « solide », etc. L'épaisseur de la couche de résine photosensible 3 est typiquement comprise entre 150 et 600 microns. Selon l'épaisseur et la technique utilisée, la résine pourra être déposée en une ou plusieurs fois.

Conformément au mode particulier de mise en oeuvre de l'invention qui fait l'objet de la présente description, après l'étape b) la couche de résine 3 est encore chauffée entre 90 et 95° C pendant une durée suffisante pour évaporer les solvants (pre-bake). L'homme du métier comprendra toutefois que selon la nature de la résine utilisée, cette étape de chauffage n'est pas forcément nécessaire.

L'étape suivante du procédé (figure 4) consiste à irradier la couche de résine au moyen d'un rayonnement UV à travers les ouvertures d'un masque 4 définissant le contour du premier niveau de la microstructure désirée. Cette irradiation UV peut par exemple être réalisée au moyen d'une aligneuse (non représentée) ayant ses pics d'intensité à 365 et 410 nm. L'ampleur de l'irradiation dépend de l'épaisseur de la résine. Elle est typiquement de 200 à 1'000 mJ/cm² mesurée à une longueur d'onde de 365 nm. Le cas échéant, une étape de recuit de la couche (post-bake) peut être nécessaire pour compléter la polymérisation induite par l'irradiation UV. Avec un photorésist négatif comme celui utilisé dans le présent exemple, l'étape de recuit est de préférence effectuée entre 90 et 95°C durant 15 à 30 minutes. Les zones insolées (photopolymérisées) 3a deviennent ainsi insensibles à une grande majorité des liquides de développement. Par contre, les zones non insolées 3b pourront ultérieurement être dissoutes en utilisant un liquide de développement adéquat.

L'étape suivante du procédé (figure 5) consiste à développer la couche de résine photosensible 3. Dans le présent exemple, le photorésist utilisé est négatif. Dans ces conditions, développer le photorésist revient à l'attaquer chimiquement, de manière à dissoudre les zones non insolées 3b et à faire apparaître par endroit la couche conductrice 2 du substrat 1. On comprendra toutefois que, dans le cas d'un photorésist positif, ce sont les zones insolées 3a qui sont dissoutes. L'homme du métier saura choisir un liquide de développement adéquat pour l'étape de développement du photorésist sur la base des indications du fabricant de la résine photosensible. Selon une variante avantageuse, il est possible de parachever l'étape de développement par une brève exposition à un plasma de manière à bien nettoyer le moule en résine et à en activer la surface en prévision de l'étape suivante.

L'étape suivante du procédé (figure 6) consiste à rendre conductrices les parties subsistantes de la surface de la couche de résine développée à l'étape précédente. Pour ce faire on procède au dépôt d'une couche de métallisation 5, par vaporisation sous vide par exemple.

On voit sur la figure 6 que la couche de métallisation 5 ne recouvre de préférence que les surfaces horizontales, de sorte que les flancs demeurent isolants. Toutefois, selon une variante non représentée, la métallisation pourrait être réalisée sur les surfaces verticales aussi bien que sur les surfaces horizontales.

D'autre part, l'homme du métier ne rencontrera aucune difficulté particulière, ni pour choisir un métal à vaporiser qui soit capable d'accrocher au photorésist, ni pour choisir un métal capable de servir de couche d'amorçage 5 pour un dépôt galvanique ultérieur. Le chrome par exemple remplit à lui-seul ces deux conditions. D'autre part, il existe des photorésists qui sont naturellement conducteurs. On comprendra que dans ce cas particulier, il n'est pas forcément nécessaire de procéder à la métallisation de la surface.

Conformément à la description ci-dessus, dans le mode de mise oeuvre qui fait l'objet du présent exemple, la surface conductrice 5 est formée sur la couche de résine photosensible après l'étape d) du procédé. Alternativement, selon une seconde variante, l'étape de former une surface conductrice sur la première couche de résine photosensible peut se placer entre l'étape b) et l'étape c) ou entre l'étape c) et l'étape d). Selon encore une autre variante, la couche conductrice peut même être formée au fond des ouvertures entre l'étape g) et l'étape h) une fois les moules en photorésist réalisés.

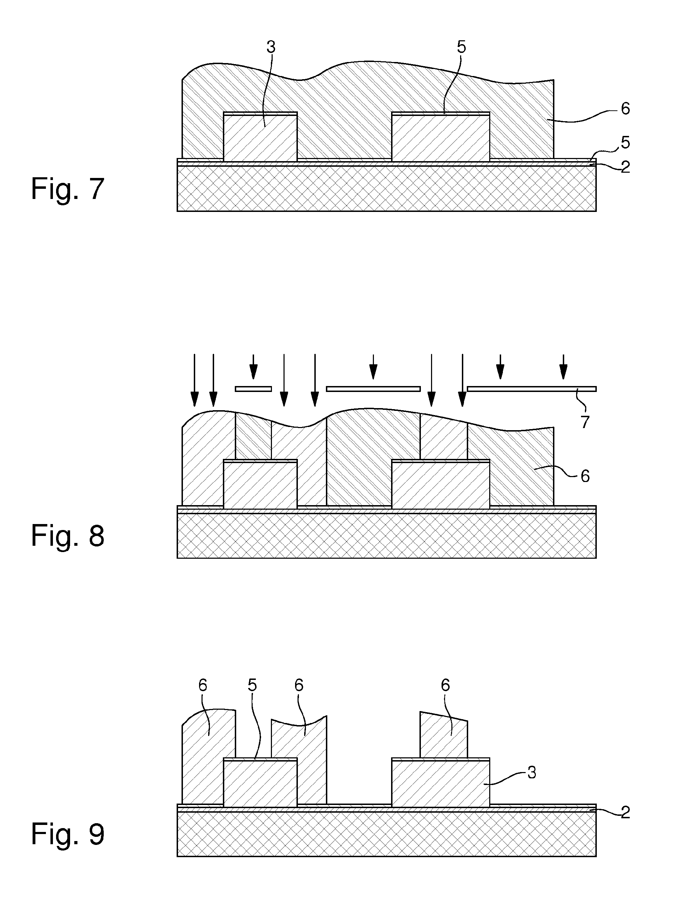

L'étape suivante du procédé (figure 7) consiste à déposer une nouvelle couche de résine photosensible 6 sur la couche de métal vaporisé 5, de manière à recouvrir cette dernière et à remplir les ouvertures dans la couche de résine développée 3. Pour cette étape, il est préférable que les ouvertures formées dans la couche de résine déjà développée 3 soient bien remplies par la résine provenant de la nouvelle couche 6. Lorsqu'un dépôt à la tournette ne donne pas des résultats satisfaisants, il est possible d'utiliser, pour réaliser la nouvelle couche de photorésist, une autre technique de dépôt. Il est par exemple possible de gicler la surface à recouvrir avec un photorésist en spray, comme le Ti spray de Michrochemicals GmbH ou même d'utiliser un photorésist positif traditionnel préalablement dilué. Il est également possible de former la nouvelle couche 6 par dépôt galvanique d'un photorésist comme le PEPR 2400 de Shipley Ltd.

Alternativement, il est également possible d'appliquer le photorésist de la nouvelle couche 6 de manière à recouvrir la couche 3 sans que le photorésist ne pénètre dans les ouvertures. Pour obtenir un tel résultat, on peut par exemple utiliser une résine « solide » que l'on peut, par exemple, faire adhérer par laminage.

L'étape suivante du procédé (figure 8) consiste à irradier la nouvelle couche de résine 6 au moyen d'un rayonnement UV à travers les ouvertures d'un masque 7 définissant le contour du deuxième niveau de la microstructure désirée. Cette étape nécessite d'aligner le masque 7 avec les ouvertures du premier niveau. L'homme du métier saura réaliser cet alignement, en se servant par exemple de marques d'alignement.

D'autre part, on peut voir sur la figure 8 que le procédé selon l'invention permet de réaliser des flancs qui s'élèvent sur deux niveaux (voir plus). Comme déjà décrit plus haut, selon la nature du photorésist utilisé, on effectue ensuite une étape de recuit de l'ensemble pour parachever la polymérisation induite par l'irradiation UV.

L'étape suivante du procédé (figure 9) consiste à développer la nouvelle couche de résine photosensible irradiée 6. La technique peut être la même que celle utilisée pour développer la première couche de photorésisit. L'étape de développer la couche de résine 6 produit un moule à deux niveaux en résine. Selon une variante, une fois cette étape effectuée, il est possible de reproduire la suite des étapes correspondant au figures 6 à 9 pour obtenir, si désiré, un moule à trois niveaux en résine.

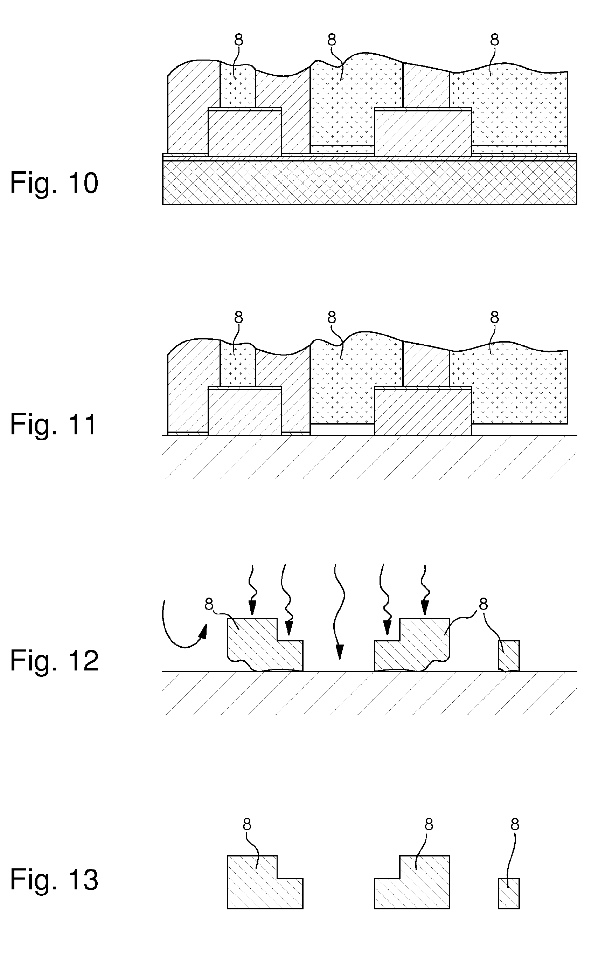

L'étape suivante du procédé (figure 10) consiste à déposer galvaniquement un métal ou un alliage dans les ouvertures du moule multi niveaux en résine. Selon une variante avantageuse, préalablement à cette étape, on procède d'abord à l'activation, aussi bien, des surfaces formant les flancs du moule en résine, que des surfaces horizontales métallisées. L'activation des surfaces permet d'améliorer l'amorçage ainsi que la régularité du dépôt galvanique. Typiquement, le métal utilisé pour le dépôt galvanique sera choisi parmi l'ensemble comprenant le nickel, le cuivre, l'or et l'argent, ou encore l'or-cuivre, le nickel-cobalt, le nickel-fer et le nickel-phosphore. En général, la structure métallique multicouche est entièrement réalisée dans le même alliage ou métal. Toutefois, il est également possible de changer de métal ou d'alliage au cours de l'étape de déposition galvanique de manière à obtenir une structure métallique comportant au moins deux couches de natures différentes. L'homme du métier saura déterminer les conditions pour le dépôt galvanique, notamment la composition du bain, la géométrie du système, les tensions et densités de courant, en fonction du métal ou de l'alliage à déposer. Il pourra se référer par exemple à Di Bari G. A. « electroforming » Electroplating Engineering Handbook 4th Edition, sous la direction de L. J. Durney, publié par Van Nostrand Reinhold Company Inc. N.Y. USA 1984.

On se reportant à nouveau à la figure 9, on peut voir que les ouvertures dans le moule en résine n'ont pas toutes la même profondeur. Certaines ouvertures laissent apparaître la couche conductrice 2 du substrat 1, alors que d'autres ouvertures ne s'étendent que jusqu'à la couche conductrice 5 qui recouvre le premier niveau de résine photosensible 3. De manière conventionnelle, l'installation de dépôt galvanique est arrangée pour maintenir la couche conductrice 2 du substrat sous tension de manière à ce que cette dernière se comporte comme une cathode. Selon la présente invention, la couche conductrice 5 qui recouvre le premier niveau de résine photosensible n'est de préférence pas reliée à la source de tension. Ainsi, dans une première phase, le dépôt galvanique ne s'effectue que sur la surface conductrice 2. Ce n'est qu'une fois que la couche de métal électro-déposé atteint la hauteur de la première couche de résine qu'elle peut entrer en contact avec la couche conductrice 5 et mettre cette dernière sous tension. Grâce à cette caractéristique, la croissance galvanique dans les différentes ouvertures peut progresser de front, ce qui permet de réaliser des structures avec des surfaces relativement planes.

L'étape suivante du procédé (figure 11) consiste à détacher du substrat l'ensemble formé par le photorésist polymérisé et la structure métallique multicouche obtenue à l'étape précédente. Dans le cas où le substrat porte une couche sacrificielle formée au début du procédé, comme expliqué plus haut, on détache la structure métallique multi niveaux par dissolution de la couche sacrificielle (figure 11) (par exemple, à l'aide d'une solution d'hydroxyde de potassium (KOH) si la couche est en aluminium).

Selon les matériaux utilisés, il est possible de détacher la structure métallique multi niveaux et le moule en résine simplement par délaminage, sans qu'il ne soit nécessaire d'attaquer et de dissoudre une couche sacrificielle. C'est le cas notamment lorsque le substrat est une plaquette métallique massive.

Une fois que la structure métallique multi niveaux et le photorésist ont été détachés du substrat, l'étape suivante (figure 12) consiste à éliminer les couches de résine photosensible pour libérer la microstructure métallique.

Selon une variante non représentée, on place encore la structure métallique multi niveaux dans un bain prévu pour éliminer les parties restantes des couches d'amorçage 2, 5.

Dans l'exemple qui fait l'objet de la présente description, le procédé comporte encore une dernière étape (figure 13) qui consiste à mettre à niveau la partie supérieure de la structure multi niveaux par des opérations de rodage et de polissage.

On comprendra en outre que diverses modifications et/ou améliorations évidentes pour un homme du métier peuvent être apportées au mode de mise en oeuvre qui fait l'objet de la présente description sans sortir du cadre de la présente invention définie par les revendications annexées.

## Revendications

1. Procédé de fabrication d'une microstructure métallique multi-niveaux par une technique de photolithographie UV et de dépôt galvanique, **caractérisé en ce qu'**il comprend les étapes consistant à :
a) se munir d'un substrat (1) comportant une surface conductrice (2) ;
b) recouvrir la surface conductrice (2) d'une première couche de résine photosensible (3) ;
c) irradier la première couche de résine photosensible (3) à travers un masque (4) correspondant à l'empreinte désirée ;
d) développer la première couche de résine photosensible (3) de manière à creuser dans celle-ci des ouvertures et à obtenir ainsi un premier niveau d'un moule en résine, les ouvertures dans la première couche de résine laissant apparaître la surface conductrice (2) du substrat ;
e) déposer une nouvelle couche de résine photosensible (6) sur la couche de résine développée (3), de manière à recouvrir cette dernière et à remplir les ouvertures dans celle-ci.
f) irradier la nouvelle couche de résine photosensible (6) à travers un masque (7) correspondant à l'empreinte désirée ;
g) développer la nouvelle couche de résine photosensible (6) de manière à creuser dans celle-ci des ouvertures et à obtenir un moule en résine multi niveaux, les ouvertures dans le moule multi niveaux laissant apparaître la surface conductrice (2) du substrat.
h) déposer galvaniquement un métal ou un alliage dans les ouvertures du moule en résine multi niveaux.
i) éliminer les couches de résine de manière à faire apparaître une structure métallique multi niveaux (8) constituée par ledit métal ou alliage déposé dans les ouvertures.

2. Procédé de fabrication selon la revendication 1, **caractérisé en ce qu'**il comporte après l'étape b), l'étape de former une surface conductrice (5) sur la première couche de résine photosensible (3) ;

3. Procédé de fabrication selon la revendication 1, **caractérisé en ce qu'**il comporte après l'étape c), l'étape de former une surface conductrice (5) sur la première couche de résine photosensible (3) ;

4. Procédé de fabrication selon la revendication 1, **caractérisé en ce qu'**il comporte après l'étape d), l'étape de former une surface conductrice (5) sur les parties subsistantes de la surface de la couche de résine (3) développée à l'étape précédente ;

5. Procédé de fabrication selon la revendication 1, **caractérisé en ce qu'**il comporte après l'étape g), l'étape de former une surface conductrice (5) au fond des dites ouvertures.

6. Procédé de fabrication selon l'une des revendications 1 à 5, **caractérisé en ce qu'**une fois l'étape g) réalisée, les étapes e) à g) sont réalisées une nouvelle fois avant de passer à l'étape h) de manière à ajouter une couche supplémentaire au moule multi niveaux.

7. Procédé de fabrication selon l'une des revendications précédentes, **caractérisé en ce que** les couches d'amorçages (2, 5) sont formées d'un empilement de couches de chrome et d'or.

8. Procédé de fabrication selon l'une des revendications précédentes, **caractérisé en ce qu'**il comprend après l'étape h) une étape consistant à aplanir la résine et le métal déposé pour amener la résine et la structure multi niveaux au même niveau.

9. Procédé de fabrication selon l'une des revendications précédentes, **caractérisé en ce** la résine photosensible déposée à l'étape 3) est une résine « solide », et qu'elle est appliquée par laminage.
